# EUROPEAN PATENT SPECIFICATION

(11) **EP 3 022 767 B1**
(45) Date of publication and mention of the grant of the patent: **21.11.2018**
(21) Application number: 14742317.2
(22) Date of filing: 15.07.2014
(51) Int. Cl.: H01L 23/498, H01L 23/538, H01L 23/13, H05K 1/02, H05K 1/18

(54) **CIRCUIT SHEET ARRANGEMENT**
LEITERPLATTENANORDNUNG
AGENCEMENT DE FEUILLE DE CIRCUIT

(30) Priority: 15.07.2013 GB 201312607
(43) Date of publication of application: 25.05.2016
(73) Proprietor: Novalia Ltd, Cambridge CB5 8RE (GB)
(72) Inventor: STONE, Kate, Cambridge Cambridgeshire CB24 9NP (GB)
(74) Representative: Piotrowicz, Pawel Jan Andrzej
(86) International application number: PCT/GB2014/052161
(87) International publication number: WO 2015/008059

(56) References cited:
- GB-A- 2 472 047
- JP-A- S 641 595
- US-A1- 2008 251 940
- US-A1- 2009 166 431
- US-A1- 2009 267 229

## Description

The present invention relates to a circuit sheet arrangement.

### Background

Electronic components are increasingly being incorporated into printed articles, such as books, posters and greeting cards, to allow printed articles to become more interactive. Examples of interactive printed articles are described in GB 2 464 537 A, WO 2004 077286 A, WO 2007 035115 A and DE 1993 4312672 A.

GB 2 482 039 A describes a device (such as a printed article, a book, a game or a greeting card) which comprises a laminate of at least two layers. Components, such as a light emitting diode, an integrated circuit, a battery etc, are provided between two layers and at least one of the layers supports a conductive track connecting the components.

GB 2 472 047 A describes a device in the form of a packaged component, such as a light emitting diode or an integrated circuit, which is formed over a slot cut in a substrate.

US2009/0267229 A1 describes a chip package structure comprising a chip and a flexible substrate layer. Leads are formed on the substrate layer and extend into an opening to pads on the chip. The opening is encapsulated to prevent short-circuit at the junctures for insulation purposes.

The devices described in GB 2 482 039 A and GB 2 472 047 A can be formed from plastic or fibre-based material such as paper or card. Accordingly, the devices tend to be flexible. However, the components tend to be inflexible and so if the devices are bent or twisted, then connections between a component and a supporting substrate may be broken.

The present invention seeks to avoid or ameliorate this problem.

### Summary

According to a first aspect of the present invention there is provided a circuit sheet arrangement as recited in claim 1.

According to a second aspect of the present invention there is provided a circuit sheet arrangement as recited in claim 2.

Thus, a stiff electronic component, such as a light emitting diode or integrated circuit, can be mounted onto the circuit sheet arrangement formed from flexible material and the arrangement can withstand flexion and/or torsion.

The flexible planar substrate may be substantially non-stretchable.

Each arm may comprise at least one turn. For example, each arm may comprise one, right-angle turn. At least some of the arms may be arranged in opposite pairs. Distal ends of each pair of arms may point in opposite directions.

The arms may be connected to a central node, such as platform. The arms and central node may be unitary, i.e. formed in the same layer of material. This central node may help the arms to maintain or to return to a stable position when not stretched or twisted.

Each arm may include one or more slits arranged to allow ends of the arms to be moved apart in the same plane. This allows the arms not only twist and bend, but also stretch or stretch further. The arm may comprise first and second opposite edges and wherein at least one slit extends from each opposite edge. The arm may have a line running midway between the opposite edges and wherein at least one slit crosses the midway line. The arm may comprise at least one slit which extends between but does not reach the opposite edges. A pair of adjacent slits (for example, along a straight section of an arm) maybe parallel.

The substrate may comprise a fibre-based material such as paper, card, or cardboard and/or plastic. The substrate may comprise a laminate.

According to a third aspect of the present invention there is provided an article comprising an electronic component and a circuit sheet arrangement as recited in claim 18.

The electronic component may be bonded to the tracks by conductive glue, conductive ink and/or conductive tape.

The article may be a printed article having indicia (words and/or images) formed of ink or paint printed thereon.

The article may be a game. The article may be a greetings card.

### Brief Description of the Drawings

Certain embodiments of the present invention will now be described, by way of example, with reference to the accompanying drawings, in which:

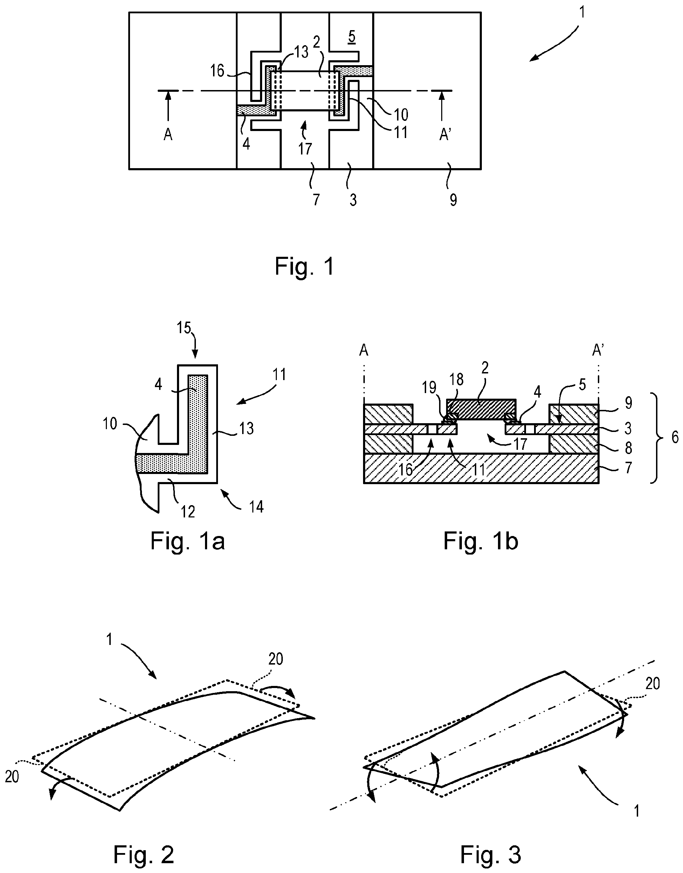

Figure 1 is a plan view of an article which includes a circuit sheet arrangement and an electronic component mounted onto the circuit sheet arrangement;
Figure 1a shows an arm portion of the circuit sheet arrangement shown in Figure 1 in more detail;
Figure 1a is a cross-sectional view an article taken along the line A-A';
Figure 2 illustrates bending of the article;
Figure 3 illustrates twisting of the article;
Figure 4 illustrates a two-arm, two-piece circuit sheet arrangement;
Figure 5 illustrates a two-arm, single-piece circuit sheet arrangement;
Figure 6 illustrates a four-arm, single-piece circuit sheet arrangement;
Figure 7 illustrates a four-arm, single-piece circuit sheet arrangement which includes a platform; and
Figure 8 illustrates a first slotting arrangement of an arm;
Figure 9 illustrates a second slotting arrangement of an arm; and
Figure 10 illustrates a more complex circuit sheet arrangement.

### Detailed Description of Certain Embodiments

Referring to Figures 1, 1a and 1b, an article 1 is shown which includes an electronic component 2 supported on a two-part circuit sheet 3 having conductive tracks 4 disposed on an upper surface 5. The conductive tracks 4 comprise conductive ink formed by a printing process, such as gravure, offset, flexography, screen or inkjet. However, the conductive tracks 4 may be formed from foil formed by stamping.

The circuit sheet 3 forms part of a laminate 6 which includes a base sheet 7, an intermediate sheet 8 and a top sheet 9. The sheets 9 comprise card and are bonded together by glue (not shown).

As shown in Figure 1a, each part of the circuit sheet 3 comprises a main portion 10 and an arm 11 extending from main portion 10. Each arm 11 is generally 'L'-shaped having first and second sections 12, 13. The first portion 12 is proximal to the main sheet portion 10 and the second portion 13 is distal to the main sheet portion 10.

The first and second sections 12, 13 are straight sections. The second portion 13 extends between an elbow 14 and a free end 15 of the arm 11. The arm 11 is formed by slots 16 running between the main sheet portion 10 and arm 11. A conductive track 4 runs along each arm 13. As will be explained in more detail later, more than one conductive track 4 can run along each arm 11.

As shown in the Figure 1, the second sections 13 are arranged opposite each other, are parallel and point in opposite directions.

A gap (or "aperture") 17 is formed between the two main sheet portions 10 of the circuit sheet parts 3. The arms 11 extend into the gap 17.

The electronic component 2 is mounted onto the arms 10 so that it bridges the gap 17. The electrical terminals 18 under the underside of the component 2 are bonded to the tracks 4 using conductive glue 19. However, a conductive tape can be used.

Referring also to Figures 2 and 3, opposite ends 20 (or sides) of the article 1 can be bent and/or twisted. However, flexional or torsional movement is at least partially decoupled from the electronic component 2 by virtue of the arms 11. Thus, stress on the connection between the glue 19 can be reduced.

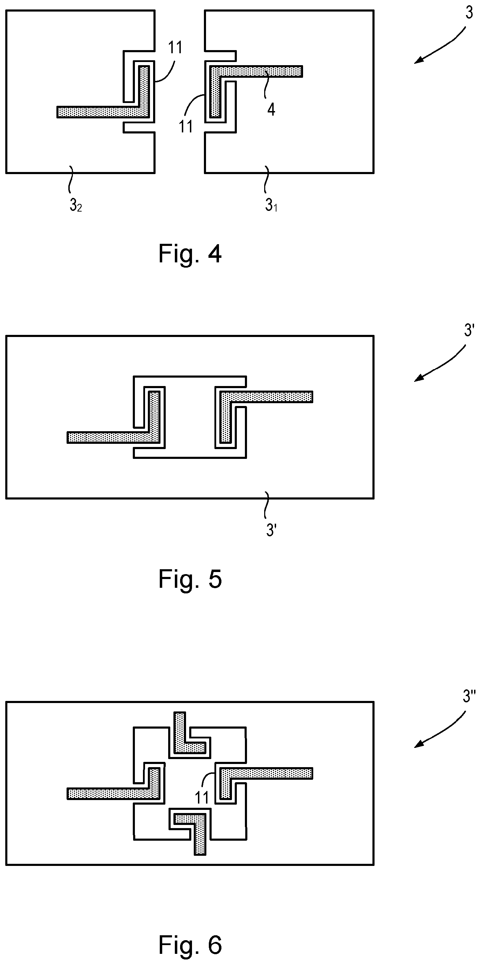

Referring to Figure 4, the circuit sheet 3 used in the article 1 shown in Figure 1 comprises two separate parts 3₁, 3₂, i.e. two sheets, and has two arms 11. The sheets 3₁, 3₂ are coplanar. This arrangement is used to form an "open" aperture, i.e. an aperture which is not necessarily surrounded by the same sheet.

Referring to Figure 5, a circuit sheet 3' may comprise a single sheet. This arrangement is used to form an "closed" aperture, i.e. an aperture which is surrounded by the same sheet.

Referring to Figure 6, a circuit sheet arrangement 3" may have more than two arms, for example, four arms 11. The arms 11 maybe arranged in pairs. For each pair, the arms are arranged are parallel and point in opposite directions. The arms may be opposite each other or may be offset (to the side).

The arms 11 need not be all the same size and/or the same configuration.

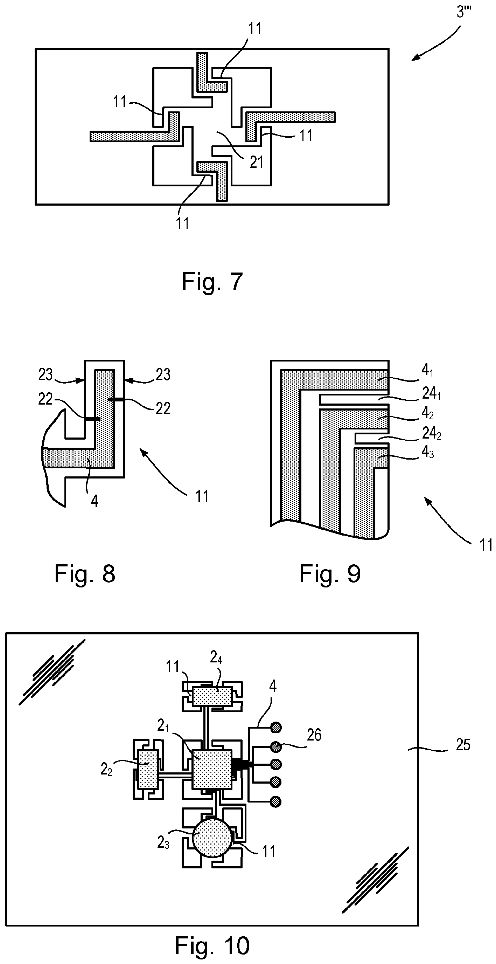

Referring to Figure 7, the circuit sheet arrangement 3"' may include a central node 21 which connects the arms 11.

Referring to Figure 8, an arm 11 may include slots 22 along extending into the body of the arm 11 from an edge 23. The arms slots 22 can be arranged in pairs along a section of the arm, extending inwardly from opposite edged and spaced along the arm. This can help the arm 11 to extend. In Figure 8, only two slots 22 are shown. However, there may be three, four or more slots 22. In Figure 8, the slots 22 also cut into the conductive track 4. However, the conductive track 4 may be configured to run between the edges 23 and between the tracks 4, i.e. to meander along the arm 11.

Referring to Figure 9, an arm 11 may include more than one track 4₁, 4₂, 4₃, for example, running in parallel. At the end of the arm, the tracks 4₁, 4₂, 4₃ may be separated by slots 24₁, 24₂. This can help to decouple movement of between the tracks and, thus, help to reduce stress of any glue (not shown) attached to the track 4₁, 4₂, 4₃ at the end of the arm 11.

Referring to Figure 10, a more complex circuit sheet arrangement 25 is shown. The circuit sheet includes four sets of arms 11 which are used to support four components on the same sheet 25. The sheet may be formed from a fibre-based material such as paper or card. The components can include a microcontroller 2₁, a battery 2₂, a buzzer 2₃ and an LED 2₄. A set of conductive pads 26, for example formed from conductive ink or foil, are provided on the sheet 25 to provide capacitive touch user input.

The more complex circuit sheet arrangement 25 may be used in an article, such as game or card. The article may be a printed article supporting printed indicia. The article may comprise laminate, for example, as described in GB 2 472 047 A. Different layers in the laminate may provide different arms. Thus, a component may be suspended in a cavity formed by several layers and may be connected to conductive tracks in different layers by arms extending from different main portions of different layers.

The articles herein described may be formed using printing and converting processes, for example, as described in GB 2 482 039 A and GB 2 472 047 A.

An article which incorporates an electronic device and in which part(s) of a circuit forming the electric device is formed on a fibre-based material can help to reduce the amount of plastic used and, thus, be more environmentally friendly.

It will be appreciated that many modifications may be made to the embodiments hereinbefore described. Such modifications may involve equivalent and other features which are already known in the design, manufacture and use of articles formed from fibre-based sheets, which are printed articles and which include conductive tracks formed from ink or foil, parts thereof and which may be used instead of or in addition to features already described herein. Features of one embodiment may be replaced or supplemented by features of another embodiment.

Card need not be used, but other fibre-based materials, such as paper can be used. Inflexible plastic or even glass can be used. Laminates of, for example card and plastic, can be used.

Although conductive ink can be used, one or more of the conductive regions, such as pads, terminals, tracks etc., can be formed from foil comprising for example, aluminium, copper, gold or aluminium, formed for example, by hot- or cold-foil stamping.

The article may be or may be used in not only in games, but also books, calendars, greeting cards, product packaging or point of sale displays.

The arms need not have straight sides or sections. The sides or sections can be curved. The arms need not have an elbow, but can be slotted. The arms can include more than one elbow.

More than one circuit sheet may be used. For example, two or sets of circuit sheet may be used to form "open" apertures and one of the circuit sheet or a different circuit sheet can be used to form one or more "closed" apertures.

## Claims

1. A circuit sheet arrangement comprising:
a flexible planar substrate (3); and
conductive tracks (4) formed on a face (5) of the flexible planar substrate (3);
wherein the flexible planar substrate (3) is configured to have an aperture (17) enclosed by a surrounding portion (10) of the flexible planar substrate (3) and to have at least two arms (11) supporting respective conductive tracks which extend into the aperture from the surrounding portions.

2. A circuit sheet arrangement comprising:
at least two co-planar, flexible planar substrates (3₁, 3₂); and
conductive tracks formed on respective faces of the at least two co-planar, flexible planar substrates (3₁, 3₂); wherein the at least two co-planar, flexible planar substrates (3₁, 3₂) are arranged around an aperture and wherein each flexible planar substrate is configured to have at least one arm supporting respective conductive tracks which extend into the aperture.

3. A circuit sheet arrangement according to claim 1 or 2, wherein the flexible planar substrate(s) (3; 3₁, 3₂) is (are) substantially non-stretchable.

4. A circuit sheet arrangement according to any preceding claim, wherein each arm (11) comprising at least one turn.

5. A circuit sheet arrangement according to claim 4, wherein each arm (11) comprising one, right-angle turn.

6. A circuit sheet arrangement according to any preceding claim, wherein at least some of the arms (11) are arranged in opposite pairs.

7. A circuit sheet arrangement according to claim 6, wherein distal ends of each pair of arms (11) point in opposite directions.

8. A circuit sheet arrangement according to any preceding claim, wherein the arms (11) are connected to a central node (21).

9. A circuit sheet arrangement according to any preceding claim, wherein each arm (11) includes one or more slits arranged to allow ends of the arms to be moved apart in the same plane.

10. A circuit sheet arrangement according to any preceding claim, wherein the arm (11) comprises first and second opposite edges and wherein at least one slit extends from each opposite edge.

11. A circuit sheet arrangement according to claim 9 or 10, the arm (11) has a line running midway between the opposite edges and wherein at least one slit crosses the midway line.

12. A circuit sheet arrangement according to claim 9, 10 or 11, wherein the arm (11) comprises at least one slit which extends between but does not reach the opposite edges.

13. A circuit sheet arrangement according to any one of claims 9 to 12, wherein a pair of adjacent slits are parallel.

14. A circuit sheet arrangement according to any preceding claim, wherein the substrate comprises paper.

15. A circuit sheet arrangement according to any preceding claim, wherein the substrate comprises card.

16. A circuit sheet arrangement according to any preceding claim, wherein the substrate comprises plastic.

17. A circuit sheet arrangement according to any preceding claim, wherein the substrate comprises a laminate.

18. An article (1) comprising:
an electronic component (2); and
a circuit sheet arrangement according to any preceding claim;
wherein the electronic component is disposed over the aperture (17) and is attached to conductive tracks on the arms.

19. An article according to claim 18, wherein the article is a game.

20. An article according to claim 18, wherein the article is a greetings card.

## Patentansprüche

1. Leiterplattenanordnung, beinhaltend:
ein flexibles planares Substrat (3); und
Leiterbahnen (4), die auf einer Fläche (5) des flexiblen planaren Substrats (3) ausgebildet sind;
wobei das flexible planare Substrat (3) konfiguriert ist, um eine Öffnung (17) aufzuweisen, die durch einen umgebenden Abschnitt (10) des flexiblen planaren Substrats (3) umschlossen ist, und um mindestens zwei Arme (11) aufzuweisen, die jeweilige Leiterbahnen stützen, die sich von den umgebenden Abschnitten in die Öffnung hinein erstrecken.

2. Leiterplattenanordnung, beinhaltend:
mindestens zwei koplanare, flexible planare Substrate (3₁, 3₂) ; und
Leiterbahnen, die auf jeweiligen Flächen der mindestens zwei koplanaren, flexiblen planaren Substraten (3₁, 3₂) ausgebildet sind;
wobei die mindestens zwei koplanaren, flexiblen planaren Substrate (3₁, 3₂) um eine Öffnung herum angeordnet sind und wobei jedes flexible planare Substrat konfiguriert ist, mindestens einen Arm aufzuweisen, der jeweilige Leiterbahnen stützt, die sich in die Öffnung hinein erstrecken.

3. Leiterplattenanordnung gemäß Anspruch 1 oder 2, wobei das/die flexible (n) planare (n) Substrat (e) (3; 3₁, 3₂) im Wesentlichen nicht dehnbar ist (sind).

4. Leiterplattenanordnung gemäß einem vorhergehenden Anspruch, wobei jeder Arm (11) mindestens eine Drehung beinhaltet.

5. Leiterplattenanordnung gemäß Anspruch 4, wobei jeder Arm (11) eine Drehung im rechten Winkel beinhaltet.

6. Leiterplattenanordnung gemäß einem vorhergehenden Anspruch, wobei mindestens einige der Arme (11) in entgegengesetzten Paaren angeordnet sind.

7. Leiterplattenanordnung gemäß Anspruch 6, wobei distale Enden von jedem Paar Arme (11) in entgegengesetzte Richtungen zeigen.

8. Leiterplattenanordnung gemäß einem vorhergehenden Anspruch, wobei die Arme (11) mit einem mittleren Knoten (21) verbunden sind.

9. Leiterplattenanordnung gemäß einem vorhergehenden Anspruch, wobei jeder Arm (11) einen oder mehrere Schlitze umfasst, die angeordnet sind, um Enden der Arme zu erlauben, in der gleichen Ebene auseinander bewegt zu werden.

10. Leiterplattenanordnung gemäß einem vorhergehenden Anspruch, wobei der Arm (11) erste und zweite entgegengesetzte Kanten beinhaltet und wobei sich mindestens ein Schlitz von jeder entgegengesetzten Kante erstreckt.

11. Leiterplattenanordnung gemäß Anspruch 9 oder 10, wobei der Arm (11) eine Linie aufweist, die mittig zwischen den entgegengesetzten Kanten verläuft, und wobei mindestens ein Schlitz die mittige Linie kreuzt.

12. Leiterplattenanordnung gemäß Anspruch 9, 10 oder 11, wobei der Arm (11) mindestens einen Schlitz beinhaltet, der sich zwischen den entgegengesetzten Kanten erstreckt, aber diese nicht erreicht.

13. Leiterplattenanordnung gemäß einem der Ansprüche 9 bis 12, wobei ein Paar angrenzender Schlitze parallel ist.

14. Leiterplattenanordnung gemäß einem vorhergehenden Anspruch, wobei das Substrat Papier beinhaltet.

15. Leiterplattenanordnung gemäß einem vorhergehenden Anspruch, wobei das Substrat eine Karton beinhaltet.

16. Leiterplattenanordnung gemäß einem vorhergehenden Anspruch, wobei das Substrat Kunststoff beinhaltet.

17. Leiterplattenanordnung gemäß einem vorhergehenden Anspruch, wobei das Substrat ein Laminat beinhaltet.

18. Artikel (1), beinhaltend:
einen elektronischen Bauteil (2); und
eine Leiterplattenanordnung gemäß einem vorhergehenden Anspruch;
wobei der elektronische Bauteil über der Öffnung (17) liegt und an Leiterbahnen auf den Armen angebracht ist.

19. Artikel gemäß Anspruch 18, wobei der Artikel ein Spiel ist.

20. Artikel gemäß Anspruch 18, wobei der Artikel eine Grußkarte ist.

## Revendications

1. Agencement de feuille de circuit, comprenant :
un substrat planaire flexible (3) ; et
des pistes conductrices (4) formées sur une face (5) du substrat planaire flexible (3) ;
le substrat planaire flexible (3) étant conçu pour avoir une ouverture (17) enfermée par une partie circonvoisine (10) du substrat planaire flexible (3), et pour avoir au moins deux bras (11) supportant des pistes conductrices respectives qui s'étendent dans l'ouverture à partir des parties circonvoisines.

2. Agencement de feuille de circuit, comprenant :
au moins deux substrats planaires flexibles coplanaires (3₁, 3₂) ; et
des pistes conductrices formées sur des faces respectives des au moins deux substrats planaires flexibles coplanaires (3₁, 3₂) ;
les au moins deux substrats planaires flexibles coplanaires (3₁, 3₂) étant disposés autour d'une ouverture, et chaque substrat planaire flexible étant conçu pour avoir au moins un bras supportant des pistes conductrices respectives qui s'étendent dans l'ouverture.

3. Agencement de feuille de circuit selon la revendication 1 ou 2, dans lequel le ou les substrats planaires flexibles (3 ; 3₁, 3₂) sont sensiblement non étirables.

4. Agencement de feuille de circuit selon l'une quelconque des revendications précédentes, dans lequel chaque bras (11) comprend au moins un tour.

5. Agencement de feuille de circuit selon la revendication 4, dans lequel chaque bras (11) comprend un tour en angle droit.

6. Agencement de feuille de circuit selon l'une quelconque des revendications précédentes, dans lequel les bras (11) sont, au moins en partie, disposés par paires opposées.

7. Agencement de feuille de circuit selon la revendication 6, dans lequel les extrémités distales de chaque paire de bras (11) sont orientées dans des directions opposées.

8. Agencement de feuille de circuit selon l'une quelconque des revendications précédentes, dans lequel les bras (11) sont connectés à un noeud central (21).

9. Agencement de feuille de circuit selon l'une quelconque des revendications précédentes, dans lequel chaque bras (11) comprend une ou plusieurs fentes conçues pour permettre l'éloignement d'extrémités des bras dans le même plan.

10. Agencement de feuille de circuit selon l'une quelconque des revendications précédentes, dans lequel le bras (11) comprend des premier et second bords opposés, et dans lequel au moins une fente s'étend à partir de chaque bord opposé.

11. Agencement de feuille de circuit selon la revendication 9 ou 10, dans lequel le bras (11) a une ligne s'étendant à mi-distance entre les bords opposés, et dans lequel au moins une fente coupe la ligne s'étendant à mi-distance.

12. Agencement de feuille de circuit selon la revendication 9, 10 ou 11, dans lequel le bras (11) comprend au moins une fente qui s'étend entre les bords opposés mais ne les atteint pas.

13. Agencement de feuille de circuit selon l'une quelconque des revendications 9 à 12, dans lequel une paire de fentes adjacentes sont parallèles.

14. Agencement de feuille de circuit selon l'une quelconque des revendications précédentes, dans lequel le substrat comprend du papier.

15. Agencement de feuille de circuit selon l'une quelconque des revendications précédentes, dans lequel le substrat comprend du carton.

16. Agencement de feuille de circuit selon l'une quelconque des revendications précédentes, dans lequel le substrat comprend du plastique.

17. Agencement de feuille de circuit selon l'une quelconque des revendications précédentes, dans lequel le substrat comprend un stratifié.

18. Article (1), comprenant :
un composant électronique (2) ; et
un agencement de feuille de circuit selon l'une quelconque des revendications précédentes ;
le composant électronique étant disposé sur l'ouverture (17) et fixé à des pistes conductrices sur les bras.

19. Article selon la revendication 18, l'article étant un jeu.

20. Article selon la revendication 18, l'article étant une carte de voeux.
